# EUROPEAN PATENT SPECIFICATION

(11) **EP 1 330 779 B1**
(45) Date of publication and mention of the grant of the patent: **02.12.2009**
(21) Application number: 00973925.1
(22) Date of filing: 27.10.2000
(51) Int. Cl.: G06F 3/033

(54) **DUAL SENSOR TOUCHSCREEN UTILIZING PROJECTIVE-CAPACITIVE AND FORCE TOUCH SENSORS**
BERÜHRUNGSEMPFINDLICHER BILDSCHIRM MIT PROJEKTIVEN KAPAZITIVEN SENSOREN UND KRAFTSENSOREN
ECRAN TACTILE A DOUBLE CAPTEUR EQUIPE D'UN CAPTEUR PROJECTIF-CAPACITIF ET D'UN CAPTEUR DE FORCE TACTILES

(43) Date of publication of application: 30.07.2003
(60) Divisional application: 09171892.4
(73) Proprietor: Tyco Electronics Corporation, Berwyn, PA 19312 (US)
(72) Inventor: KENT, Joel, Fremont, CA 94536 (US); WILSON, Geoffrey, D., Oxnard, CA 93031 (US)
(74) Representative: Johnstone, Douglas Ian
(86) International application number: PCT/US2000/029602
(87) International publication number: WO 2002/035461

(56) References cited:
- EP-A- 0 421 025
- US-A- 5 801 682

## Description

### TECHNICAL FIELD OF THE INVENTION

The present invention relates generally to touchscreens and, more particularly, to a method and apparatus for discriminating between a false touch event and a true touch on a touchscreen.

### BACKGROUND OF THE INVENTION

Touchscreens are used in conjunction with a variety of display types, including cathode ray tubes (*i*.*e*., CRTs) and liquid crystal display screens (*i*.*e*., LCD screens), as a means of inputting information into a data processing system. When placed over a display or integrated into a display, the touchscreen allows a user to select a displayed icon or element by touching the screen in a location corresponding to the desired icon or element. Touchscreens have become common place in a variety of different applications including, for example, point-of-sale systems, information kiosks, automated teller machines (*i*.e., ATMs), data entry systems, *etc*.

A variety of touchscreen types have been developed. Unfortunately each type of touchscreen has at least one weakness limiting its usefulness in at least some applications. For example, the cover sheet in a resistive touchscreen is susceptible to damage such as surface scratches or cuts due to malicious vandalism. Even repeated screen compressions may eventually damage a resistive touchscreen. This type of touchscreen is also susceptible to environmental damage, for example moisture entering the display. A second type of touchscreen, thin dielectric layer capacitive touchscreens, have problems with gloved hands. Thick dielectric layer capacitive touchscreens, also referred to as projective capacitive touchscreens, have problems with non-tactile feel and palm rejection. A third type of touchscreen utilizing surface acoustic waves is susceptible to the accumulation of contaminants, *e*.*g*., raindrops, on the surface of the sensor. Contamination can also interfere with the operation of infrared touchscreens. Also infrared touchscreens require special effort to avoid signal problems due to direct sunlight. A fifth type of touchscreen using force sensors is susceptible to shock and vibration.

Various systems have been designed that utilize two different touchscreen technologies for a variety of purposes, primarily as a means of accommodating different touch mechanisms, *e*.*g*., a finger and a stylus, for data entry.

U.S. Patent No. 5,231,381 corresponds to EP-A-0 421 025 (on which the preambles of the independent claims are based) and which discloses a multi-purpose data input device utilizing an integrated touchscreen and a digitizing tablet. The touchscreen detects the presence and location of a passive input (*e*.*g*., finger touch) through any of a variety of techniques including surface acoustic wave, force, capacitive, or optical touch sensors. The digitizing tablet employs an active stylus mechanism to stimulate a capacitive, inductive, or surface acoustic wave sensor.

U.S. Patent No. 5,510,813 discloses a touch panel that measures both touch position and touch force. The touch panel uses a resistive, conductive layer and determines touch position by monitoring the current pattern. The force of the touch is determined by monitoring a capacitance value between the touch panel and a second conductive panel that extends substantially parallel to the touch panel. In response to a touch, the system processes both the detected position and the detected force of the touch.

U.S. Patent No. 5,543,589 discloses a dual sensor touchscreen in which each sensor determines touch position, but with a different resolution. The two sensors are sandwiched together to form a single sensor, thus allowing a single touch by a finger, stylus, *etc*. to be detected by both sensors. In use, the wide conductors of the low resolution sensor are first scanned in order to determine touch position to within a rectangular area the size of one wide conductor. To determine the touch location with the higher resolution sensor, only the narrow conductors corresponding to the rectangular area of touch determined with the low resolution sensor must be scanned. Thus the system disclosed is intended to reduce the number of scan drivers and receivers required, thus lowering cost as well as speeding up the scanning process.

U.S. Patent No. 5,670,755 discloses a touch panel that can be used in either of two modes. In one mode, the touch panel operates like a conventional touchscreen, allowing a user to input information by touching the screen with a finger, pen, or other touching medium. In this mode two resistive layers applied to the panel come into contact at the point of touch. The determination of the contact location is based on resistance ratios. In a second mode, the touch panel functions as a digitizer using a specially designed stylus. Capacitance coupling at the contact point of the stylus to the panel is used in determining the contact point.

U.S. Patent No. 5,777,607 discloses a system that senses finger touch capacitively and stylus touch resistively. In either touch mode the disclosed system is able to determine the x- and y-coordinates of the touch on the touchscreen using a single resistive layer. In the preferred embodiment, the finger detection mode is disabled when the system detects the stylus is in use, thus preventing the inadvertent input of data through capacitive coupling with the user's hand.

U.S. Patent No. 5,801,682 discloses a dual sensor touchscreen in which the variations in coordinate data from a capacitive sensor are compensated for by the use of strain gauges mounted at the corners of the sensor. Variations in the capacitive sensor data may result from changes in signal path, for example, due to the user wearing gloves.

What is needed in the art is a method and apparatus for discriminating against false touches of the sort that may result from external stimuli or for confirming the presence of touch. The present invention provides such a method and apparatus, a method and apparatus that is particularly well suited for outdoor applications.

### SUMMARY OF THE INVENTION

The present invention provides a method and apparatus for discriminating against false touches in a touchscreen system. The system utilizes multiple touchscreen sensors of differing types to validate a touch on a touchscreen. Thus the invention utilizes the strengths of specific sensor types to overcome the deficiencies of other sensor types, particularly with respect to the demands of outdoor and semi-outdoor applications where supervision is limited and rain drops and/or other contaminants may be present.

The basis of the invention lies in the ability to confirm a touch registered by one touch sensor with another touch sensor. If the touch is confirmed, the touch can be acted upon, for example by sending touch coordinates to the operating system. If, on the other hand, the touch is not confirmed, the touch is invalidated. The system can be designed such that there is a primary touch sensor that determines the touch coordinates and a secondary sensor that validates the presence of a touch, by either a discrete signal or by generating a second set of touch coordinates for comparison purposes. Furthermore, the touch coordinates can either be determined before or after the initial touch is confirmed. The combination of force and projective capacitive sensor systems is particularly well suited to meet the needs of demanding outdoor and semi-outdoor touch applications.

In an embodiment of the invention, projective-capacitive and force sensors are utilized, both of which are capable of providing accurate touch position coordinates. The system may be designed to determine which sensor is most likely to provide accurate position coordinates for a given set of conditions.

According to a first aspect of the invention there is provided a touchscreen system, comprising: a plurality of force sensors coupled to a touchscreen of said touchscreen system; a plurality of electrodes coupled to said touchscreen, wherein a first portion of said plurality of electrodes are formed along a first axis and a second portion of said plurality of electrodes are formed along a second axis; a projective-capacitive sensor system including said plurality of electrodes; and a processor coupled to said plurality of force sensors and said projective-capacitive sensor system, wherein said processor calculates a set of position coordinates of a touch of said touchscreen when said plurality of force sensors and said projective-capacitive sensor system substantially simultaneously detect said touch, **characterised in that** said processor is set up to determine an offset between primary touch position coordinates from output of said projective-capacitive sensor system and secondary touch position coordinates from output of said force sensors.

According to a second aspect of the invention there is provided a method of operating a touchscreen system, comprising the steps of: detecting a force applied to a touchscreen of said touchscreen system with a plurality of force sensors, wherein said detected force corresponds to a touch of said touchscreen; confirming said touch of said touchscreen detected by said force sensors with a projective-capacitive sensor; generating a set of position coordinates corresponding to said touch; and transmitting said set of position coordinates to a touchscreen operating system, **characterised in that** generating said set of position coordinates includes determining an offset between primary touch position coordinates from output of said projective-capacitive sensor and secondary touch position coordinates from output of said force sensors.

A further understanding of the nature and advantages of the present invention may be realized by reference to the remaining portions of the specification and the drawings.

### BRIEF DESCRIPTION OF THE DRAWINGS

Fig. 1 is a flow chart illustrating the basic methodology of the present invention;
Fig. 2 is a flow chart illustrating an alternate methodology of the present invention;
Fig. 3 is an illustration of a force sensor;
Fig. 4 is an illustration of one or more force sensors applied to a touchscreen;
Fig. 5 is an illustration of a projective-capacitive touch sensor;
Fig. 6 is a cross-sectional view of the projective-capacitive touch sensor shown in Fig. 5;
Fig. 7 is a flow chart illustrating the method used with an embodiment of the invention in which both the projective-capacitive and force touch sensors provide touch position coordinates;
Fig. 8 is an illustration of a generic block circuit diagram for a sensor element readout circuit;
Fig. 9 is an illustration of a projective-capacitive sensor element for use with the circuit of Fig. 8; and
Fig. 10 is an illustration of a force sensor element for use with the circuit of Fig. 8.

### DESCRIPTION OF THE SPECIFIC EMBODIMENTS

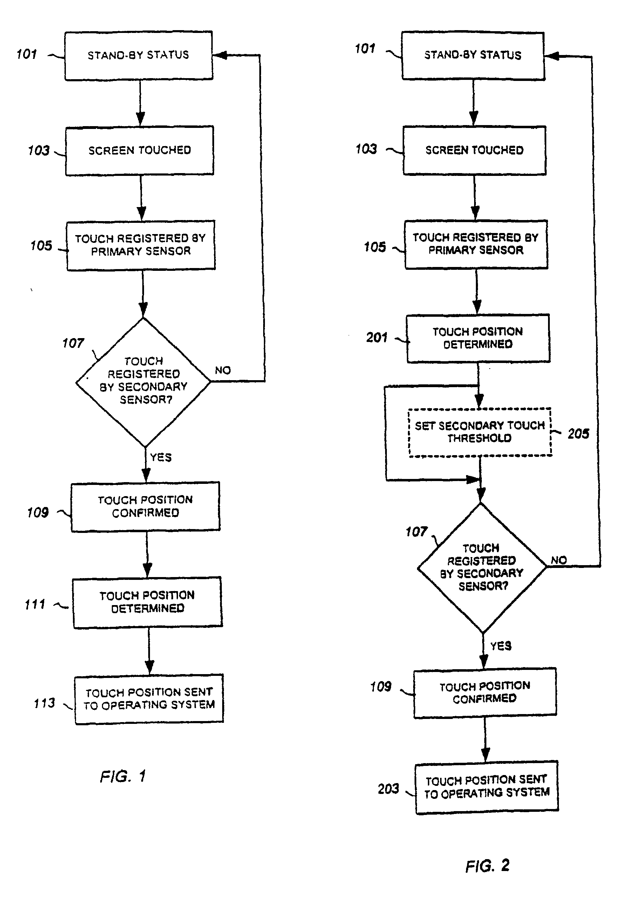

Fig. 1 is a flow chart illustrating the preferred operation of the present invention. At step 101, the touchscreen is in a pre-touch, stand-by status. The screen then receives a touch (step 103), for example via a finger, perhaps gloved. The primary touch sensor then registers a touch (step 105). Prior to the primary touch sensor determining the coordinates of the touch or sending any information to the operating system (*e*.*g*., touch position, touch mode, *etc*.), a secondary sensor confirms that the touch received by the primary sensor is a valid touch (step 107). If the secondary sensor confirms that the touch is valid (step 109), the touch position coordinates are determined (step 111). Depending upon the desired configuration, the coordinates of the touch position can be determined by either the primary sensor or the secondary sensor. The touch controller then sends the touch information (*e*.*g*., touch position coordinates) to the operating system (step 113). If the secondary sensor does not confirm that a valid touch was received by the primary sensor, no touch information is sent to the operating system and the touch sensor is placed back into stand-by status 101. The benefit of this embodiment is that time is not spent on determining invalid touch positions, thus enabling the system to quickly confirm that a valid touch has been received and if the touch is invalidated, to quickly return to stand-by status 101.

In a slight modification of the system illustrated in Fig. 2, after the primary sensor registers a touch (step 105), it determines the position of the touch (step 201). After determining touch position, the system can simply query the secondary sensor to determine it has also registered a touch (step 107) and if it has, confirm the touch (step 109) and send the position coordinates to the operating system (step 203). Alternately, after the touch position has been determined (step 201), a coordinate dependent touch threshold is set for the secondary sensor (step 205), thus accounting for coordinate dependent touch sensitivities.

In the preferred embodiment of the invention, one of the sensors, preferably the secondary sensor, only determines whether or not a touch has been received. Since this sensor does not determine absolute touch position, it can be an inexpensive sensor. Alternately, this sensor can be designed to determine approximate touch position. For example, this sensor can be designed to determine what quadrant of the screen has been touched. In a third alternative this sensor can be designed to determine the actual coordinates of the touch position, thus providing system redundancy.

Preferably one of the sensors is a projective-capacitive sensor and the other is a force sensor. The system can be designed such that either of these sensors acts as the primary or touch position coordinate determining sensor while the other sensor acts simply as the validation sensor. In at least one embodiment of the invention, both sensors accurately determine the touch coordinates thus providing redundancy as well as a more sophisticated method of validating touch. Alternatively, one of the sensors can accurately determine the touch coordinates while the second sensor approximates the touch coordinates (*e*.*g*., to within a touchscreen quadrant).

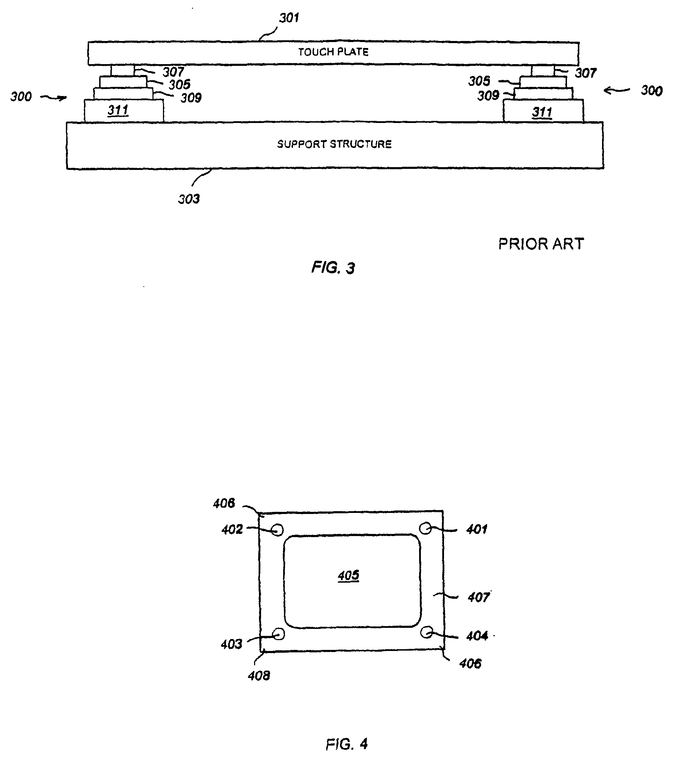

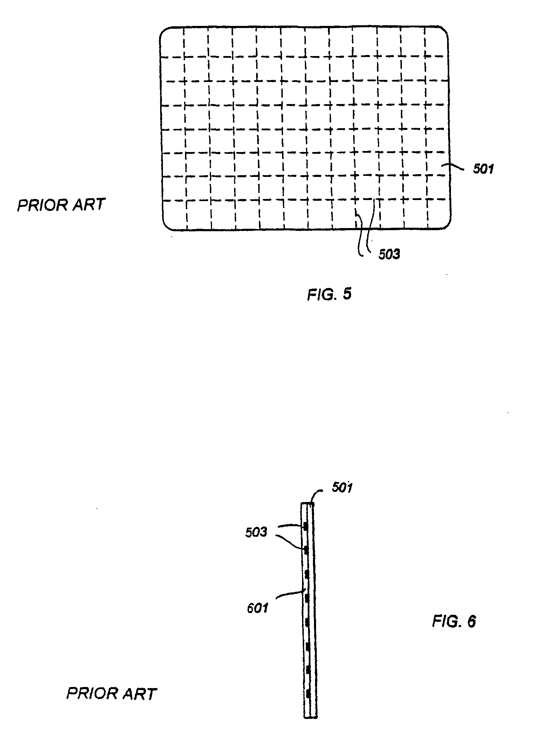

The design and use of force sensors in a touchscreen are well known by those of skill in the art and therefore will not be discussed in detail in the present specification. Force sensors are typified by temperature compensated strain gauges such as those disclosed in U.S. Patent No. 5,742,222. Force sensors can also be based on peizo systems, such as those disclosed in U.S. Patent Nos. 4,355,202 and 4,675,569 and European Patent Application No. EP 0 754 936. Preferably the present invention employs a pressure sensitive force sensor such as that illustrated in UK Patent Application Nos. GB 2 310 288 A, GB 2 321 707 A, and GB 2 326 719. Fig. 3, based on Fig. 5a of UK Patent Application No. GB 2 321 707 A, illustrates two such force sensors 300.

As shown, piezo-resistive force sensors 300 may be placed between one or more corners of a touch plate 301 and a support structure 303. Each force sensor 300 is comprised of a piezo-resistive material 305, the resistance of which changes as it is compressed. A top electrode 307 and a bottom electrode 309 permit electronic measurement of the resistance of piezo-resistive material 305. A sensor substrate 311 is provided to assure a mechanically robust force sensor construction. Insulating layers (not shown) may be added to provide electrical isolation as needed. In order to easily measure small percentage changes in resistance, the read-out electronics typically places force sensors 300 within a Wheatstone bridge.

The type of force sensors illustrated in Fig. 3 offer a number of advantages. First, the design supports an environmentally rugged construction that is immune to ambient temperature and humidity variations. Second, they directly measure compressive force. Third, because they can withstand very large bias compressions, they can be mechanically integrated as a simple washer in bolted assemblies.

The force sensors can be coupled to the touchscreen in either an overlay or non-overlay configuration and can utilize one or multiple sensors, depending upon whether the force sensor(s) is to supply touch validation or touch coordinates. In the simplest configuration, as shown in Fig. 4, a single force sensor 401 is located on a touchscreen 405. In the case of a single force sensor, low-stiffness supports at corners 406 and high-stiffness supports at corner 408 may be used to avoid zones of limited or no touch sensitivity. Preferably sensor 401 is located just outside of the viewing region of screen 405 and underneath a touchscreen cowling 407. Alternately, four force sensors 401-404 may be used, one located at each corner of touchscreen 405 to provide touch coordinates in a manner similar to that disclosed in U.S. Patent No. 5,708,460.

It should be understood that a single force sensor 401 typically has a touch sensitivity that is dependent upon the location of the touch position. This sensitivity also depends upon the manner in which touchscreen 405 is mounted (*e*.*g*., rigid mounts versus soft mounts). Therefore if a single force sensor is to be used to supply touch validation, preferably the touch threshold of the force sensor is set on the basis of the touch position as determined by the projective capacitive sensor described below.

The other sensor used in the preferred embodiment of the invention is a projective-capacitive sensor. Figs. 5 and 6 provide front and cross-sectional views, respectively, of a projective-capacitive touch sensor, such as that disclosed in U.S. Patent No. 5,844,506. In this configuration, deposited on substrate 501 is a pattern of electrodes 503, formed using fine wire electrodes, patterned resistive coatings, or other standard electrode designs. A protective overlay 601 prevents electrodes 503 from being damaged during use. As previously noted, projective-capacitive sensors 503 can be used either to provide the absolute touch position or simply to provide touch confirmation. Typically the spacing of the electrodes is given by the application, *i*.*e*., fine spacing for absolute position and course spacing for simple touch confirmation.

Projective-capacitive touchscreens, such as that shown above and those disclosed in U.S. Patent Nos. 5,650,597 and 4,954,823 and PCT patent applications WO 95/27334 and 96/15464, monitor the change in touchscreen capacitance. Unlike a thin dielectric layer capacitive sensor, however, the capacitance of a projective-capacitive sensor is changed not only by touching the sensor with a grounded object, but also by simply bringing a grounded object into close proximity to the sensor. Thus the principal difficulty with this type of touchscreen is due to the various sizes of the grounded objects that can be used with the screen. For example, a small finger (*e*.*g*., a child's finger) will produce a substantially smaller signal than a large finger. Similarly, a person wearing gloves, as may be expected in some outdoor applications, will produce a significantly smaller signal than an ungloved hand. Another problem can result by the user simply getting too close to a portion of the screen, for example by leaning a hand against a surface that is in close proximity to the screen. Therefore a simple signal-level threshold system is not sufficient for determining the actual point of contact with a projective-capacitive sensor since, depending on the threshold, it may indicate a touch prior to the occurrence of the actual touch (*e*.*g*., large user hand with a touchscreen that has been set to recognize a child's fingers) or completely disregard a touch (*e*.*g*., disregard a child's finger because the screen is set-up for an adult finger).

In contrast to touchscreens based on projective-capacitive sensors, touchscreens utilizing force sensors do not have recognition problems with fingers of varying size. Nor do force sensors have difficulty in recognizing gloved hands, styluses, pens, *etc*. Force sensor touchscreens do, however, suffer from false signals caused by mechanical noise. For example, vibrations to the touchscreen can cause vibrations in the reference mass, thus generating extraneous background signals. Additionally, the extraneous background signals may cause the system to be unable to recognize a valid touch.

In outdoor applications, force sensor based touchscreens can experience touch position errors due to the wind. For example, if a wind is blowing parallel to the touchscreen, a person standing in front of the touchscreen will cause an asymmetry in the pressure applied to the left and right-hand portions of the screen. Due to this pressure imbalance, the touchscreen force sensors will erroneously identify the coordinates of a touch. The amount of positional error is subject to the degree of pressure asymmetry applied to the touchscreen by the wind. This asymmetry is dependent upon the wind speed, the angle between the wind and the screen parallel, the degree to which the air flow is modified by the obstacle (*i*.*e*., the user), the size of the screen, and the amount of force applied by the user's touch.

Another problem with force sensors is associated with attempting to achieve a drag and untouch functionality. In order to achieve this functionality, the force sensor signals must be processed well into the sub-Hertz range. Unfortunately some types of force sensors (*e*.*g*., piezoelectric sensors) generate signals that are essentially the time derivatives of the applied force, thus making sub-Hertz information problematic. Even force sensors that generate signals that are proportional to the applied force may have problems processing sub-Hertz information due to mechanical noise.

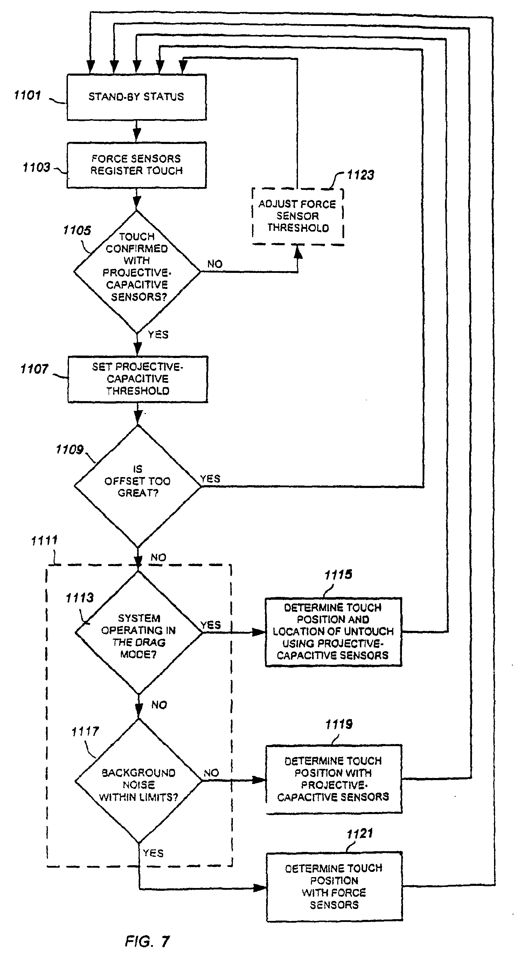

In one embodiment of the invention, both the projective-capacitive and force touch sensor systems are capable of providing touch position coordinates. In this embodiment the system touch algorithm is designed to determine which sensor system is likely to provide the most accurate position for the given conditions. The system then obtains touch coordinates from the designated system. Fig. 7 illustrates the method used with this dual sensor system.

Initially the touch system is in a stand-by mode (step 1101). Preferably the initial touch is detected by the force sensors (step 1103), thus avoiding the proximity errors that can occur with the projective-capacitive sensors. Once a touch has been detected and confirmed with the secondary sensor system *(i.e.,* the projective-capacitive sensors in the preferred embodiment) (step 1105), the touch algorithm adjusts the threshold of the projective-capacitive sensors in order to overcome differences in finger size or conductivity (step 1107). Since both sensors provide full positional accuracy, the next step is to determine the offset between the two touch positions registered by the two sensors (step 1109). If the offset is greater than is reasonable (*i*.*e*., greater than can be accounted for due to wind, hand size, *etc*.), the system invalidates the touch and returns to stand-by mode. If the offset between the two touch positions is within acceptable limits, the touch is verified and the process continues.

The touch algorithm next determines which touch sensor to use in determining touch coordinates (step 1111). For example, the touch algorithm can recognize that the system is being used in a drag mode by determining that the touch position is changing prior to an untouch message being sent (step 1113). In this instance preferably the projective-capacitive system is used to determine both touch position and the location at which untouch occurs (step 1115) since this system is generally better suited for supporting the drag mode as noted above. Alternately, if the system determines that the vibrational or wind generated background noise is too great (step 1117) the touch algorithm can select the projective-capacitive system to provide touch positions (step 1119). Otherwise the force sensors can be used to determine touch position (step 1121).

In a slight modification of this embodiment, if the projective-capacitive sensors do not confirm the touch initially detected by the force sensors (step 1105), the system can adjust the force sensor thresholds (step 1123) prior to returning the system to the stand-by mode. Either the amplitude threshold or the frequency filter for the force sensors can be adjusted.

Besides overcoming the deficiencies of both sensor systems, the combination of sensors described above has other advantages. For example, in the system stand-by mode, only one of the sensor systems needs to be in the ready state. Thus the other sensor system can be in a completely unpowered state, thereby reducing power consumption. For example, the force sensors can remain in the alert state and, once triggered, the projective-capacitive electrodes can be scanned.

Another advantage of the above combined sensors is the possibility of obtaining limited user identification. For example, a right-handed user, due to the capacitance of the user's hand, tends to project a touch position with the projective-capacitive system that is to the right of the point of contact as determined by the force sensors. Similarly, a left-handed user tends to project a touch position that is to the left of the point of contact as determined by the force sensors. Other touch attributes that can be used in an identification system are offset between the touch positions determined by the two systems, the force used to touch the screen, the speed at which the user touches multiple areas on the screen, and the time between a user's initial touch and their untouch. The system can be designed to monitor only certain touch strokes (*e*.*g*., user code for an ATM machine), or all touch strokes. One potential use of the data is to provide different users with different menus, touchscreens, *etc*. based on past use.

The use of multiple touch sensors typically does not require multiple sets of electronics since much of the electronics associated with a touchscreen controller is independent of the type of detector. For example, a typical touchscreen controller requires a microprocessor, RAM, ROM, an analog-to-digital converter (ADC), power supply circuitry, digital circuits to support communication with the host computer, and a printed circuit board. Thus in many cases much of the electronics associated with the touchscreen can be used to support multiple sensor systems.

In some instances, other aspects of the controller electronics may be common to two different types of sensors. For example, some types of piezoresistive force sensors can be read out with an alternating-current excitation voltage in the tens of kiloHertz range as opposed to the more typical approach of using a direct-current excitation voltage. Therefore the same excitation frequency and similar receive electronics can be used for both the force sensors and the projective-capacitive sense electrodes.

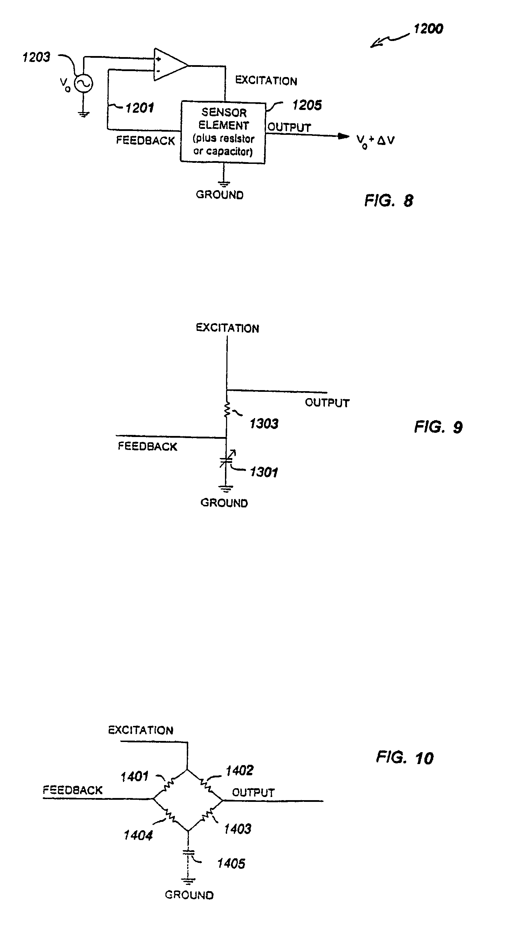

Fig. 8 is an illustration of a generic block circuit diagram for a sensor element readout circuit 1200. Negative feedback assures that the voltage on a feedback line 1201 is the same as the oscillating voltage V₀ produced by a reference 1203. The output from a sensor element 1205 is the signal voltage ΔV superposed on the reference voltage V₀. The output line plus a reference voltage line provide a differential signal output voltage ΔV.

Fig. 9 illustrates a projective-capacitive sensor element for use with the circuit of Fig. 8. A variable capacitor 1301 represents the projective-capacitive sensor electrode. In use, a user's finger or other grounded object causes the capacitance to ground to be increased. A resistor 1303 supports the readout scheme. Resistor 1303 can either be built directly into the sensor or located with the readout electrodes.

The feedback circuit illustrated in Fig. 8 can also be used with the alternating current readout of a force sensor. Some force sensors, for example those manufactured by C-Cubed Limited, are read out via a Wheatstone bridge. Thus, as shown in Fig. 10, one or more of the four resistors 1401-1404 may correspond to piezoresistive elements in the force sensor. In the embodiment shown, the bridge is connected to ground via a capacitor 1405. Although capacitor 1405 is not required, it may useful for reducing the differences between the excitation and feedback voltages, thereby making the ratio of ΔV to V₀ more similar to signals from the projective-capacitive electrodes.

As will be understood by those familiar with the art, the present invention may be embodied in other specific forms without departing from the scope of the claims. Accordingly, the disclosures and descriptions herein are intended to be illustrative, but not limiting, of the scope of the invention which is set forth in the following claims.

## Claims

1. A touchscreen system, comprising:
a plurality of force sensors (401-404) coupled to a touchscreen (405) of said touchscreen system;
a plurality of electrodes (503) coupled to said touchscreen (405), wherein a first portion of said plurality of electrodes (503) are formed along a first axis and a second portion of said plurality of electrodes (503) are formed along a second axis;
a projective-capacitive sensor system including said plurality of electrodes (503); and
a processor (701) coupled to said plurality of force sensors (401-404) and said projective-capacitive sensor system, wherein said processor (701) calculates a set of position coordinates of a touch of said touchscreen (405) when said plurality of force sensors (401-404) and said projective-capacitive sensor system substantially simultaneously detect said touch,
**characterised in that** said processor (701) is set up to determine (1109) an offset between primary touch position coordinates from output of said projective-capacitive sensor system and secondary touch position coordinates from output of said force sensors (401-404).

2. The touchscreen system of claim 1 wherein the processor (701) includes means for setting a force threshold which increases said force threshold when said projective-capacitive sensor system does not register said touch substantially simultaneously with said force sensors (401-404).

3. The touchscreen system of claims 1 or 2 including means to return said touchscreen system to a stand-by mode if the offset is greater than a predetermined offset threshold.

4. The touchscreen system of claim 1, 2 or 3 including means for comparing a background mechanical noise level with a noise threshold, wherein said set of position coordinates is generated by said force sensors (401-404) if said background mechanical noise level is less than said noise threshold, and wherein said set of position coordinates is generated by said projective-capacitive sensor system if said background mechanical noise level is greater than said noise threshold.

5. The touchscreen system of any preceding claim including means for determining if said touchscreen system is operating in a drag mode, wherein said set of position coordinates is generated by said force sensor if said touchscreen system is not operating in said drag mode, and wherein said set of position coordinates is generated by said projective-capacitive sensor system if said touchscreen system is operating in said drag mode.

6. A method of operating a touchscreen system, comprising the steps of:
detecting (1103) a force applied to a touchscreen (405) of said touchscreen system with a plurality of force sensors (401-404), wherein said detected force corresponds to a touch of said touchscreen (405);
confirming (1105) said touch of said touchscreen (405) detected by said force sensors (401-404) with a projective-capacitive sensor;
generating (1115, 1119, 1121) a set of position coordinates corresponding to said touch; and
transmitting said set of position coordinates to a touchscreen operating system,
**characterised in that** generating said set of position coordinates includes determining (1109) an offset between primary touch position coordinates from output of said force sensors (401-404) and secondary touch position coordinates from output of said projective-capacitive sensor.

7. The method of claim 6, further comprising the step of returning said touchscreen system to a stand-by mode if a negative response to said confirming step is received from said projective-capacitive sensor.

8. The method of claim 6, further comprising the step (1123) of setting a force sensor threshold if a negative response to said confirming step (1105) is received from said projective-capacitive sensor.

9. The method of claim 6, further comprising the step (1109) of returning said touchscreen system to a stand-by mode (1101) if the offset is greater than a predetermined offset threshold.

10. The method of claim 6, further comprising the steps of:
determining a background mechanical noise level; and
comparing (1117) said background mechanical noise level with a noise threshold, wherein said set of position coordinates is generated (1121) by said force sensors (101-104) if said background mechanical noise level is less than said noise threshold, and wherein said set of position coordinates is generated (1119) by said projective-capacitive sensor if said background mechanical noise level is greater than said noise threshold.

11. The method of claim 6, further comprising the step of determining (1113) if said touchscreen system is operating in a drag mode, wherein said set of position coordinates is generated (1121) by said force sensor (101-104) if said touchscreen system is not operating in said drag mode, and wherein said set of position coordinates is generated (1115) by said projective-capacitive sensor if said touchscreen system is operating in said drag mode.

## Patentansprüche

1. Berührungsempfindliches Bildschirmsystem, das Folgendes umfasst:
mehrere Kraftsensoren (401-404), die an einen berührungsempfindlichen Bildschirm (405) des berührungsempfindlichen Bildschirmsystems gekoppelt sind,
mehrere Elektroden (503), die an den berührungsempfindlichen Bildschirm (405) gekoppelt sind, wobei ein erster Teil der mehreren Elektroden (503) längs einer ersten Achse geformt ist und ein zweiter Teil der mehreren Elektroden (503) längs einer zweiten Achse geformt ist,
ein projektiv-kapazitives Sensorsystem, das die mehreren Elektroden (503) einschließt, und einen Prozessor (701), der an die mehreren Kraftsensoren (401-404) und das projektiv-kapazitive Sensorsystem gekoppelt ist, wobei der Prozessor (701) einen Satz von Positionskoordinaten einer Berührung des berührungsempfindlichen Bildschirms (405) berechnet, wenn die mehreren Kraftsensoren (401-404) und das projektiv-kapazitive Sensorsystem im Wesentlichen gleichzeitig die Berührung erfassen,
**dadurch gekennzeichnet, dass** der Prozessor (701) dafür eingerichtet ist, eine Versetzung zwischen primären Berührungspositionskoordinaten aus der Ausgabe des projektiv-kapazitiven Sensorsystems und sekundären Berührungspositionskoordinaten aus der Ausgabe der mehreren Kraftsensoren (401-404) zu bestimmen (1109).

2. Berührungsempfindliches Bildschirmsystem nach Anspruch 1, wobei der Prozessor (701) Mittel zum Festsetzen eines Kraftschwellenwertes einschließt, die den Kraftschwellenwert steigern, wenn das projektiv-kapazitive Sensorsystem die Berührung nicht im Wesentlichen gleichzeitig mit den Kraftsensoren (401-404) verzeichnet.

3. Berührungsempfindliches Bildschirmsystem nach Anspruch 1 oder 2, das Mittel einschließt, um das berührungsempfindliche Bildschirmsystem zu einem Bereitschaftsmodus zurückzuführen, falls die Versetzung größer ist als ein vorbestimmter Versetzungsschwellenwert.

4. Berührungsempfindliches Bildschirmsystem nach Anspruch 1, 2 oder 3, das Mittel einschließt, um einen mechanischen Hintergrundgeräuschpegel mit einem Geräuschschwellenwert zu vergleichen, wobei der Satz von Positionskoordinaten durch die Kraftsensoren (401-404) erzeugt wird, falls der mechanische Hintergrundgeräuschpegel geringer ist als der Geräuschschwellenwert, und wobei der Satz von Positionskoordinaten durch das projektiv-kapazitive Sensorsystem erzeugt wird, falls der mechanische Hintergrundgeräuschpegel größer ist als der Geräuschschwellenwert.

5. Berührungsempfindliches Bildschirmsystem nach einem der vorhergehenden Ansprüche, das Mittel einschließt, um zu bestimmen, ob das berührungsempfindliche Bildschirmsystem in einem Schleppmodus arbeitet, wobei der Satz von Positionskoordinaten durch den Kraftsensor erzeugt wird, falls das berührungsempfindliche Bildschirmsystem nicht in dem Schleppmodus arbeitet, und wobei der Satz von Positionskoordinaten durch das projektiv-kapazitive Sensorsystem erzeugt wird, falls das berührungsempfindliche Bildschirmsystem in dem Schleppmodus arbeitet.

6. Verfahren zum Betreiben eines berührungsempfindlichen Bildschirmsystems, wobei das Verfahren die folgenden Schritte umfasst:
Erfassen (1103) einer Kraft, die auf einen berührungsempfindlichen Bildschirm (405) des berührungsempfindlichen Bildschirmsystems ausgeübt wird, mit mehreren Kraftsensoren (401-404), wobei die erfasste Kraft einer Berührung des berührungsempfindlichen Bildschirms (405) entspricht,
Bestätigen (1105) der durch die Kraftsensoren (401-404) erfassten Berührung des berührungsempfindlichen Bildschirms (405) mit einem projektiv-kapazitiven Sensor,
Erzeugen (1115, 1119, 1121) eines Satzes von Positionskoordinaten, die der Berührung entsprechen, und
Weiterleiten des Satzes von Positionskoordinaten an ein Betriebssystem des berührungsempfindlichen Bildschirms,
**dadurch gekennzeichnet, dass** das Erzeugen des Satzes von Positionskoordinaten einschließt, eine Versetzung zwischen primären Berührungspositionskoordinaten aus der Ausgabe der Kraftsensoren (401-404) und sekundären Berührungspositionskoordinaten aus der Ausgabe des projektiv-kapazitiven Sensors zu bestimmen (1109).

7. Verfahren nach Anspruch 6, das ferner den Schritt umfasst, das berührungsempfindliche Bildschirmsystem zu einem Bereitschaftsmodus zurückzuführen, falls von dem projektiv-kapazitiven Sensor eine negative Reaktion auf den Bestätigungsschritt empfangen wird.

8. Verfahren nach Anspruch 6, das ferner den Schritt (1123) umfasst, einen Kraftsensor-Schwellenwert festzusetzen, falls von dem projektiv-kapazitiven Sensor eine negative Reaktion auf den Bestätigungsschritt (1105) empfangen wird.

9. Verfahren nach Anspruch 6, das ferner den Schritt (1109) umfasst, das berührungsempfindliche Bildschirmsystem zu einem Bereitschaftsmodus zurückzuführen(1101), falls die Versetzung größer ist als ein vorbestimmter Versetzungsschwellenwert.

10. Verfahren nach Anspruch 6, das ferner die folgenden Schritte umfasst:
Bestimmen eines mechanischen Hintergrundgeräuschpegels und
Vergleichen (1117) des mechanischen Hintergrundgeräuschpegels mit einem Geräuschschwellenwert, wobei der Satz von Positionskoordinaten durch die Kraftsensoren (101-104) erzeugt wird (1121), falls der mechanische Hintergrundgeräuschpegel geringer ist als der Geräuschschwellenwert, und wobei der Satz von Positionskoordinaten durch den projektiv-kapazitiven Sensor erzeugt wird (1119), falls der mechanische Hintergrundgeräuschpegel größer ist als der Geräuschschwellenwert.

11. Verfahren nach Anspruch 6, das ferner den Schritt umfasst, zu bestimmen (1113), ob das berührungsempfindliche Bildschirmsystem in einem Schleppmodus arbeitet, wobei der Satz von Positionskoordinaten durch den Kraftsensor (101-104) erzeugt wird (1121), falls das berührungsempfindliche Bildschirmsystem nicht in dem Schleppmodus arbeitet, und wobei der Satz von Positionskoordinaten durch den projektiv-kapazitiven Sensor erzeugt wird (1115), falls das berührungsempfindliche Bildschirmsystem in dem Schleppmodus arbeitet.

## Revendications

1. Système d'écran tactile, comprenant:
une pluralité de capteurs de force (401-404) couplés à un écran tactile (405) dudit système d'écran tactile;
une pluralité d'électrodes (503) couplées audit écran tactile (405), dans lequel une première partie de ladite pluralité d'électrodes (503) est formée le long d'un premier axe et une seconde partie de ladite pluralité d'électrodes (503) est formée le long d'un second axe;
un système de capteur projectif-capacitif incluant ladite pluralité d'électrodes (503); et un processeur (701) couplé à ladite pluralité de capteurs de force (401-404) et audit système de capteur projectif-capacitif, dans lequel ledit processeur (701) calcule un ensemble de coordonnées de position d'un effleurement dudit écran tactile (405) lorsque ladite pluralité de capteurs de force (401-404) et ledit système de capteur projectif-capacitif détectent de manière sensiblement simultanée ledit effleurement,
**caractérisé par le fait que** ledit processeur (701) est configuré pour déterminer (1109) un décalage entre des coordonnées de position d'effleurement primaires fournies par une sortie dudit système de capteur projectif-capacitif et des coordonnées de position d'effleurement secondaires fournies par une sortie desdits capteurs de force (401-404).

2. Système d'écran tactile selon la revendication 1, dans lequel le processeur (701) inclut un moyen de réglage d'un seuil de force qui augmente ledit seuil de force lorsque ledit système de capteur projectif-capacitif n'enregistre pas ledit effleurement de manière sensiblement simultanée avec lesdits capteurs de force (401-404).

3. Système d'écran tactile selon les revendications 1 ou 2, incluant un moyen pour ramener le système d'écran tactile dans un mode de veille si le décalage est supérieur à un seuil de décalage prédéterminé.

4. Système d'écran tactile selon la revendication 1, 2 ou 3, incluant un moyen pour comparer un niveau de bruit mécanique d'arrière-plan à un seuil de bruit, dans lequel ledit ensemble de coordonnées de position est généré par lesdits capteurs de force (401-404) si ledit niveau de bruit mécanique d'arrière-plan est inférieur audit seuil de bruit et dans lequel ledit ensemble de coordonnées de position est généré par ledit système de capteur projectif-capacitif si ledit niveau de bruit mécanique d'arrière-plan est supérieur audit seuil de bruit.

5. Système d'écran tactile selon l'une quelconque des revendications précédentes, incluant un moyen pour déterminer si ledit système d'écran tactile fonctionne en mode Glisser, dans lequel ledit ensemble de coordonnées de position est généré par ledit capteur de force si ledit système d'écran tactile ne fonctionne pas dans ledit mode Glisser et dans lequel ledit ensemble de coordonnées de position est généré par ledit système de capteur projectif-capacitif si ledit système d'écran tactile fonctionne dans ledit mode Glisser.

6. Procédé pour commander un système d'écran tactile, comprenant les étapes de:
détection (1103) d'une force appliquée à un écran tactile (405) dudit système d'écran tactile à l'aide d'une pluralité de capteurs de force (401-404), dans lequel ladite force détectée correspond à un effleurement dudit écran tactile (405);
confirmation (1105) dudit effleurement dudit écran tactile (405) détecté par lesdits capteurs de force (401-404) par un capteur projectif-capacitif;
génération (1115, 1119, 1121) d'un ensemble de coordonnées de position correspondant audit effleurement; et
transmission dudit ensemble de coordonnées de position à un système de commande d'écran tactile,
**caractérisé par le fait que** la génération dudit ensemble de coordonnées de position inclut la détermination (1109) d'un décalage entre des coordonnées de position d'effleurement primaires fournies par une sortie desdits capteurs de force (401-404) et des coordonnées de position d'effleurement secondaires fournies par une sortie dudit capteur projectif-capacitif.

7. Procédé selon la revendication 6, comprenant, en outre, l'étape consistant à ramener ledit système d'écran tactile dans un mode de veille si une réponse négative à ladite étape de confirmation est reçue dudit capteur projectif-capacitif.

8. Procédé selon la revendication 6, comprenant, en outre, l'étape (1123) consistant à régler un seuil de capteur de force si une réponse négative à ladite étape de confirmation (1105) est reçue dudit capteur projectif-capacitif.

9. Procédé selon la revendication 6, comprenant, en outre, l'étape (1109) consistant à ramener ledit système d'écran tactile dans un mode de veille (1101) si le décalage est supérieur à un seuil de décalage prédéterminé.

10. Procédé selon la revendication 6, comprenant, en outre, les étapes de:
détermination d'un niveau de bruit mécanique d'arrière-plan; et
comparaison (1117) dudit niveau de bruit mécanique d'arrière-plan avec un seuil de bruit, dans lequel ledit ensemble de coordonnées de position est généré (1121) par lesdits capteurs de force (101-104) si ledit niveau de bruit mécanique d'arrière-plan est inférieur audit seuil de bruit et dans lequel ledit ensemble de coordonnées de position est généré (1119) par ledit capteur projectif-capacitif si ledit niveau de bruit mécanique d'arrière-plan est supérieur audit seuil de bruit.

11. Procédé selon la revendication 6, comprenant, en outre, l'étape consistant à déterminer (1113) si ledit système d'écran tactile fonctionne en mode Glisser, dans lequel ledit ensemble de coordonnées de position est généré (1121) par ledit capteur de force (101-104) si ledit système d'écran tactile ne fonctionne pas dans ledit mode Glisser et dans lequel ledit ensemble de coordonnées de position est généré (1115) par ledit capteur projectif-capacitif si ledit système d'écran tactile fonctionne dans ledit mode Glisser.
